Europäisches Patentamt

European Patent Office

Office européen des brevets

(19)

(11) Numéro de publication : **0 139 583**
**B1**

(12) **FASCICULE DE BREVET EUROPÉEN**

(45) Date de publication du fascicule du brevet :
04.05.88

(51) Int. Cl.⁴ : **H 03 B   5/36**

(21) Numéro de dépôt : 84402015.6

(22) Date de dépôt : 08.10.84

(54) **Oscillateur à quartz pour très hautes fréquences.**

(30) Priorité : 14.10.83 FR 8316384

(43) Date de publication de la demande :
02.05.85 Bulletin 85/18

(45) Mention de la délivrance du brevet :
04.05.88 Bulletin 88/18

(84) Etats contractants désignés :
DE GB NL SE

(56) Documents cités :
DE-A- 1 541 561
FR-A- 1 473 273
FR-A- 1 475 807
MICROWAVE JOURNAL, vol. 25, no. 2, février 1982,
pages 91-93 , Dedham, US; S. NEYLON: "Hybrid saw
oscillators"
L'ONDE ELECTRIQUE, vol. 46, no. 466, janvier 1966,
pages 105-110, Paris, FR; P. VOVELLE: "Une nouvelle
application des quartz: Les oscillateurs a fréquence
contrôlée"

(73) Titulaire : **COMPAGNIE D'ELECTRONIQUE ET DE PIE-
ZO-ELECTRICITE - C.E.P.E.**
**44, rue de la Glacière**
**F-95100 Argenteuil (FR)**

(72) Inventeur : **Chauvin, Jacques**
**THOMSON-CSF SCPI 173, bld Haussmann**
**F-75379 Paris Cedex 08 (FR)**
Inventeur : **Canzian, Patrice**
**THOMSON-CSF SCPI 173, bld Haussmann**
**F-75379 Paris Cedex 08 (FR)**

(74) Mandataire : **Ruellan-Lemonnier, Brigitte et al**
**THOMSON-CSF SCPI 19, avenue de Messine**
**F-75008 Paris (FR)**

## Description

La présente invention a pour objet un oscillateur à quartz pour très hautes fréquences.

On connaît, par DE-A-1 541 561, un oscillateur à quartz, notamment pour un fonctionnement en harmoniques, comportant un premier transistor monté en base commune et un second transistor servant d'adaptateur d'impédance. Ce document divulgue la compensation de la capacité parasite du quartz par une self. Le document « Microwave Journal, vol. 25, n° 2, février 1982, pages 91-93, Dedham, US » dans un article de S. Neylon intitulé « Hybrid saw oscillators » décrit un oscillateur pour très hautes fréquences, employant un élément fonctionnant en ondes acoustiques de surface et utilisant des circuits adaptateurs d'impédances.

Il est connu d'obtenir des très hautes fréquences, de l'ordre du GHz, par multiplication de la fréquence d'un oscillateur à quartz. Cependant, si une telle opération de multiplication conserve à peu près le facteur de qualité de l'oscillateur, le rapport signal/bruit se trouve dégradé. Si n est le facteur de multiplication de fréquence, la dégradation du rapport signal/bruit, exprimé en décibel, est égale à 20 log n.

Le problème se pose donc de réaliser des oscillateurs permettant d'obtenir des fréquences aussi élevées que possible en fréquence directe.

L'invention propose un schéma électronique d'oscillateur à quartz qui permette d'atteindre des fréquences au moins égales à 1 GHz en fréquence directe.

L'invention a donc pour objet un oscillateur à quartz pour très hautes fréquences comportant un amplificateur et une boucle de réaction comprenant un quartz dont une fréquence de résonance donnée est choisie comme fréquence e l'oscillateur, l'amplificateur ayant un gain tel qu'en boucle ouverte la condition de gain de Barkhausen soit satisfaite, le quartz étant compensé à ladite fréquence par un circuit parallèle comprenant au moins une self, caractérisé en ce que la fréquence de résonance choisie est au moins égale à 1 GHz, l'amplificateur comporte un transistor monté en émetteur commun, la boucle de réaction comprenant également un filtre passe-haut assurant une coupure des fréquences inférieures à ladite fréquence de résonance, des circuits adaptateurs permettent, d'une part, l'adaptation des impédances de la boucle de réaction à l'amplificateur et, d'autre part, que cette boucle de réaction présente un déphasage nul à 2 kπ près, (k étant un nombre entier), un diviseur de puissance permet de prélever une partie du signal de la boucle de réaction pour l'injecter dans un amplificateur de sortie.

Selon une variante, la boucle de réaction comporte un circuit d'accord électronique de fréquence. Ce circuit d'accord peut comporter un condensateur fixe disposé en série dans la boucle de réaction et aux bornes duquel est branchée une diode Varicap alimentée par un circuit de commande de tension.

Ledit filtre assurant une coupure des fréquences inférieures à la fréquence de résonance comporte avantageusement un filtre en comprenant un condensateur série variable encadré de deux selfs dont une borne est à la masse.

Selon un mode de réalisation, l'oscillateur est réalisé sous forme de ligne. Il comporte des composants discrets distribués le long des sections de lignes de la boucle de manière à réaliser l'adaptation d'impédance de la boucle et la longueur cumulée des sections de lignes est telle que la boucle présente un déphasage nul à 2 kπ près. Dans le cas où le filtre mentionné ci-dessus est un filtre en π, les deux selfs peuvent être des sections de lignes de longueur inférieure au quart de la longueur d'onde de la fréquence de l'oscillateur. Le diviseur de puissance peut être un diviseur de puissance de type Wilkinson. L'invention sera mieux comprise à la lecture de la description qui va suivre donnée à titre d'exemple non limitatif, en liaison avec les figures annexées où :

la figure 1 représente le schéma de principe d'un oscillateur ;

la figure 2 représente la courbe de réponse d'un quartz possédant une fréquence de résonance au voisinage de 1 GHz ;

la figure 3 représente la courbe de réponse du quartz après compensation selon l'invention ;

la figure 4 représente la courbe de réponse du quartz après compensation et adaptation selon l'invention ;

la figure 5 représente la courbe de réponse d'un transistor hyperfréquence monté en émetteur commun ;

la figure 6 représente la courbe de réponse en boucle ouverte de l'oscillateur selon l'invention ;

les figures 7a et 7b représentent en coupe un quartz pour très haute fréquence et le schéma électrique équivalent ;

la figure 7c représente le schéma électrique équivalent d'un quartz compensé selon l'invention ;

la figure 8 représente un filtre passe-bas F en π ;

la figure 9 représente un schéma d'un oscillateur selon l'invention ;

la figure 10 représente une réalisation d'un oscillateur selon l'invention sous forme de ligne micro-ruban ;

la figure 11 représente un mode de réalisation d'un oscillateur selon l'invention mettant en œuvre des composants discrets.

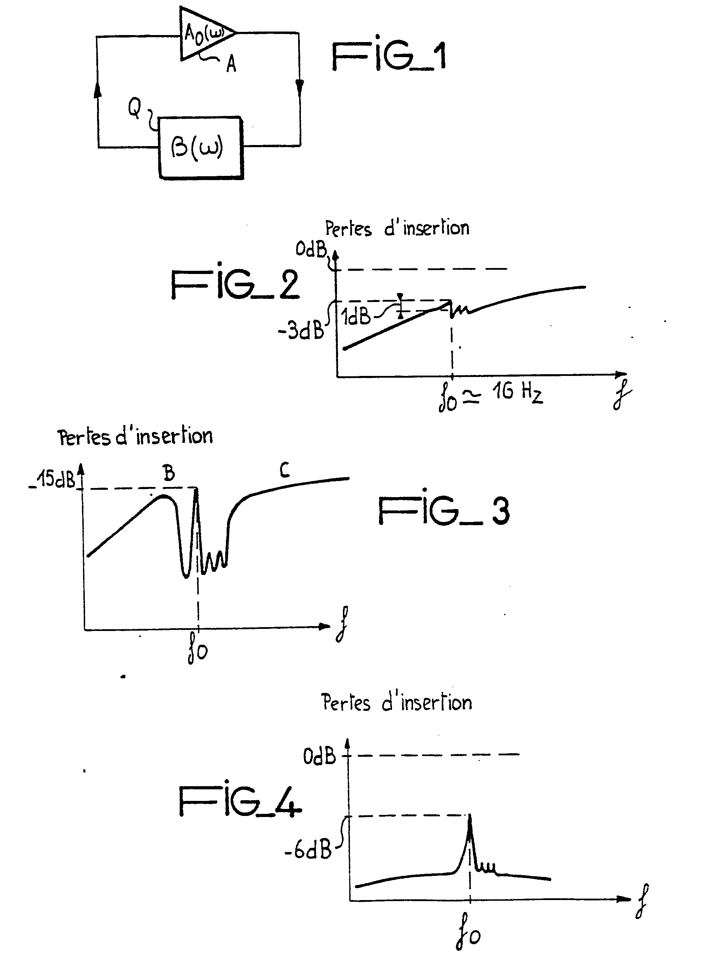

Selon la figure 1, un oscillateur se compose essentiellement d'un amplificateur A, présentant un gain $A_0(\omega)$, réactionné par un quadripôle présentant une courbe de réponse $\beta(\omega)$. Pour que l'oscillateur fonctionne, il faut que le produit $A_0.\beta$ soit très légèrement supérieur à 1 à la fréquence de l'oscillateur. Plus précisément, le gain en boucle ouverte $A_0.\beta$ exprimé en décibels doit être égal à environ 2 à 3 décibels. Ceci représente la condition de gain de Barkhausen. Pour éviter d'avoir recours à des amplificateurs de gains élevés, on a intérêt à limiter les pertes d'insertion du quartz de telle sorte que $\beta$ se rapproche autant que possible de 1.

D'autre part, on rappellera que tout oscillateur s'accroche sur une fréquence pour laquelle le déphasage total en boucle ouverte est nul modulo $2\pi$.

Selon la figure 2, un pic de résonance de fréquence $f_0$ très voisine de 1 GHz, correspondant au partiel 5 d'un quartz, présente une dynamique faible de l'ordre de 1 dB, avec une perte d'insertion de — 3 dB à la fréquence $f_0$.

Une telle courbe de réponse est totalement impropre à la réalisation d'un oscillateur à quartz, eu égard notamment à la faible dynamique du pic à fréquence $f_0$. De ce fait, l'homme du métier était dissuadé de réaliser des oscillateurs en fréquence directe dans la gamme du GHz.

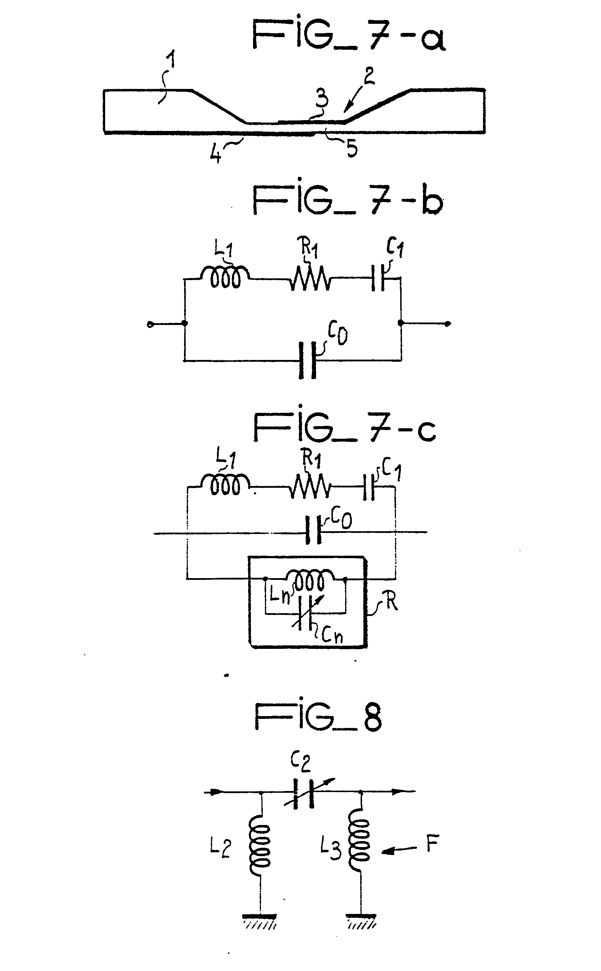

Si on se reporte aux figures 7a et 7b, un tel quartz UHF se présente sous la forme d'un disque 1 dans lequel a été creusée une cuvette 2 délimitant une membrane mince 5, dont l'épaisseur est de quelques microns présentant donc un partiel 5 de fréquence $f_0$ voisine de 1 GHz. Chaque face de la membrane 5 porte une électrode, l'une 3 étant située dans la cuvette 2, et l'autre 4 étant située à la face inférieure du disque 1.

Le schéma équivalent d'un tel quartz se compose de deux branches en parallèle, l'une comportant une self $L_1$, une résistance $R_1$, une capacité $C_1$ en série, et l'autre une capacité $C_0$. Cette capacité $C_0$ n'est autre que le condensateur délimité par les portions d'électrodes 3 et 4 qui sont en vis-à-vis dans la cuvette 2 et dont il constitue le diélectrique.

La Demanderesse a constaté que la faible dynamique du pic de fréquence $f_0$ est essentiellement due au fait que la capacité $C_0$ court-circuite pratiquement le quartz à la fréquence $f_0$.

Selon l'invention, on réalise une compensation à la fréquence $f_0$ permettant d'éliminer l'influence néfaste de la capacité $C_0$. A cet effet, on branche aux bornes du quartz une self de compensation $L_n$ de manière à réaliser un circuit bouchon à la fréquence $f_0$ éliminant l'influence néfaste de $C_0$.

Il vient :

$$L_n \times C_0\, \omega_0^2 = 1 \qquad \text{avec} \qquad \omega_0 = 2\,\pi f_0\,.$$

$\omega_0$ est défini par la relation :

$$L_1 \times C_1 \times \omega_0^2 = 1\,.$$

En pratique, on branche également aux bornes du quartz un condensateur variable $C_n$ permettant de parfaire l'ajustement qui doit satisfaire la relation :

$$L_n \times (C_n + C_0)\, \omega_0^2 = 1\,.$$

Cette compensation permet d'obtenir une courbe de réponse dont l'allure est donnée à la figure 3. Sur celle-ci, on voit que la dynamique du pic de fréquence $f_0$ a augmenté considérablement. Par contre, la perte d'insertion a également augmenté pour atteindre environ — 15 dB.

Ce pic $f_0$ se trouve en outre entouré de deux « lobes » B et C pratiquement de même niveau. Si on introduit un tel quartz dans un oscillateur, le démarrage de celui-ci aura plus de chance de s'effectuer sur les fréquences indésirables correspondant aux lobes B et C plutôt que sur la fréquence $f_0$. En effet, le démarrage d'un oscillateur s'opère grâce au bruit de fond existant du voisinage de la fréquence de l'oscillateur. Les « lobes » B et C intéressent un spectre de fréquence beaucoup plus large que le pic $f_0$, et sont de ce fait susceptibles de recueillir considérablement plus de bruit de fond assurant le démarrage de l'oscillateur.

Selon l'invention, on élimine l'influence des lobes B et C en adaptant les impédances dans la boucle de réaction. On obtient ainsi une courbe de réponse dont l'allure est donnée à la figure 4 où le pic $f_0$ présente une dynamique suffisante et où la perte d'insertion se trouve de plus réduite à — 6 dB environ. Cette valeur résulte en pratique d'un compromis car l'adaptation ne se fait pas forcément sur l'impédance propre du quartz pour des raisons qui seront plus précisément exposées dans la suite de la description.

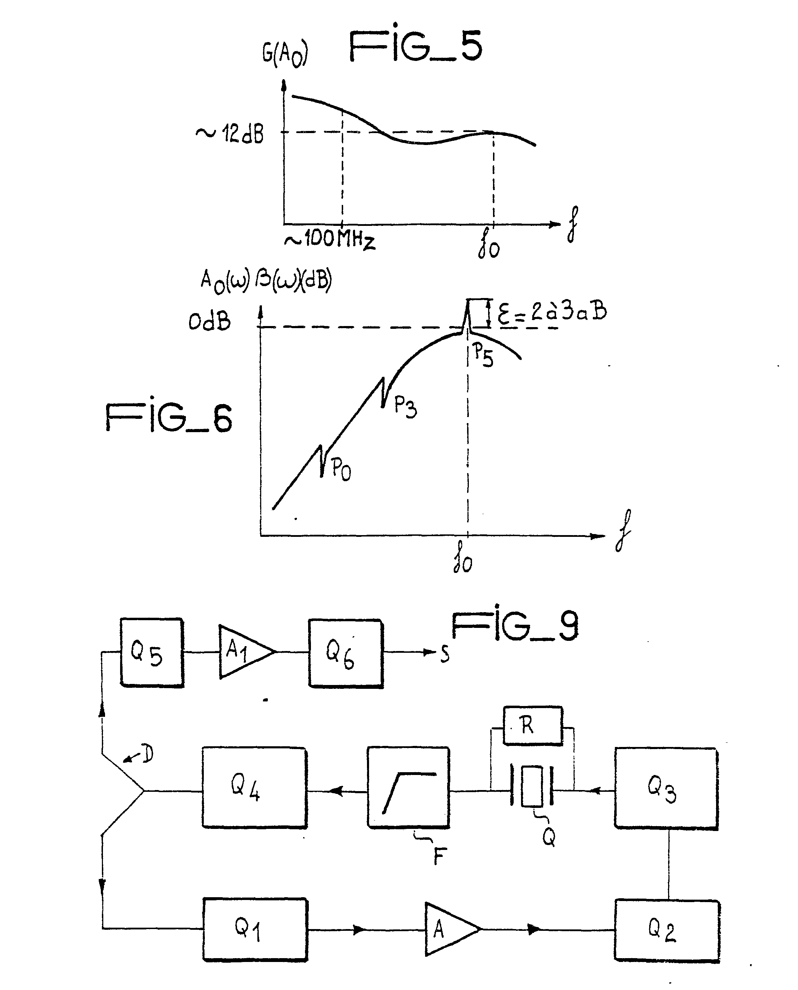

Selon la figure 5, la courbe de gain d'un transistor UHF monté en émetteur commun présente une remontée aux alentours de 100 MHz, remontée préjudiciable car elle risque d'entraîner la saturation de la boucle. A cet effet, on dispose un filtre passe-haut F atténuant les fréquences inférieures à $f_0$.

Après compensation, adaptation d'impédance et filtrage, la courbe de réponse de l'oscillateur présente la forme de la figure 6. Seul le pic de résonance de la fréquence $f_0$ correspond à un gain en boucle ouverte supérieur à 0 dB. Le gain est en effet inférieur à 0 dB tant pour les fréquences situées en dessous de $f_0$ sous l'action du filtre passe-haut F, que pour les fréquences supérieures à $f_0$ par le fait que le transistor présente une fréquence de coupure produisant une atténuation des fréquences supérieures à $f_0$. Il va de soi que si cette atténuation produite par le transistor n'est pas suffisante, le filtre F peut-être complété de manière à lui faire remplir la fonction de filtre passe-bande centré sur $f_0$.

3

Selon la figure 9, l'oscillateur comporte un amplificateur A qui est attaqué à son entrée par un quadripôle d'adaptation $Q_1$ et ses signaux de sortie attaquent un quadripôle d'adaptation $Q_2$.

La boucle de réaction se compose d'un quadripôle d'adaptation $Q_3$ en aval de $Q_2$, du quartz Q avec son réseau de compensation R, du filtre passe-haut F et d'un quadripôle d'adaptation $Q_4$.

La sortie du quadripôle $Q_4$ attaque un diviseur de puissance D dont une branche réinjecte les signaux de sortie de $Q_4$ à l'entrée de $Q_1$, et dont l'autre branche dirige une fraction des signaux en sortie de $Q_4$ vers un amplificateur de sortie $A_1$ par l'intermédiaire d'un quadripôle d'adaptation $Q_5$. Les signaux en sortie de l'amplificateur de sortie $A_1$ sont dirigés vers la sortie S par l'intermédiaire d'un quadripôle d'adaptation $Q_6$.

On comprendra par la suite de la description que les quadripôles d'adaptation sont des éléments de ligne et/ou des composants discrets disposés de manière à réaliser une adaptation d'impédance. Dans le domaine des hautes fréquences, l'adaptation d'impédance est une technique classique. On réalise par exemple une telle opération en mesurant à l'aide d'un analyseur de réseau les paramètres (habituellement dénommés paramètres S) d'entrée et sortie de chacun des quadripôles avant leur adaptation, et en calculant le ou les éléments d'adaptation à introduire dans le quadripôle considéré. De telles formules de calcul sont données dans l'ouvrage de P. GRIVET intitulé « Physique des lignes de HF et d'UHF », Tome 2, « Circuits et amplis micro-ondes », édité par MASSON et Cie.

On trouvera à la figure 8 un exemple de réalisation du filtre F sous la forme d'un filtre en $\pi$ comportant un condensateur variable $C_2$ encadré par deux selfs respectivement $L_2$ et $L_3$ dont une borne est à la masse.

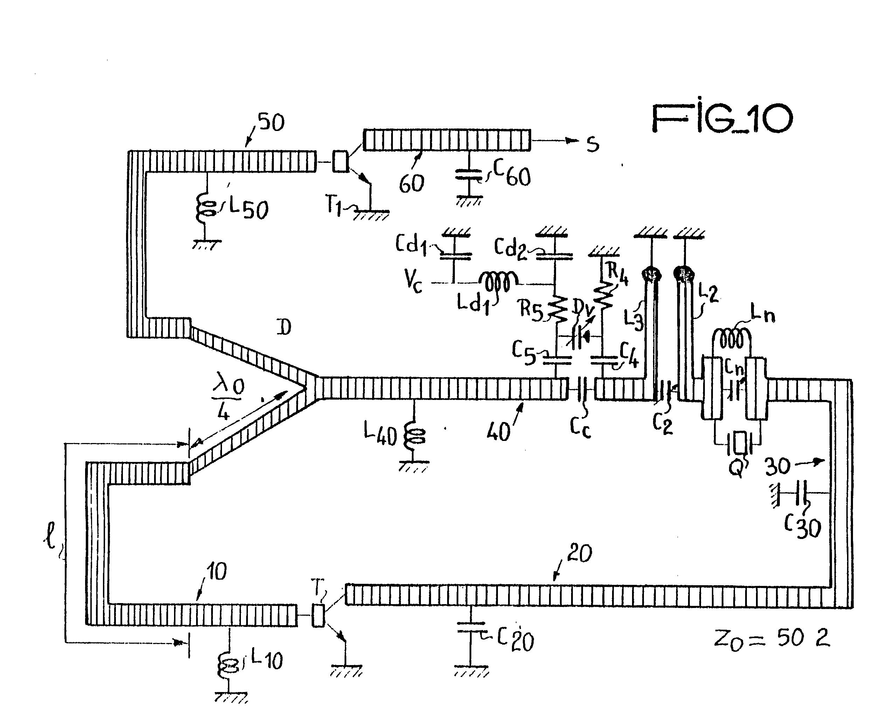

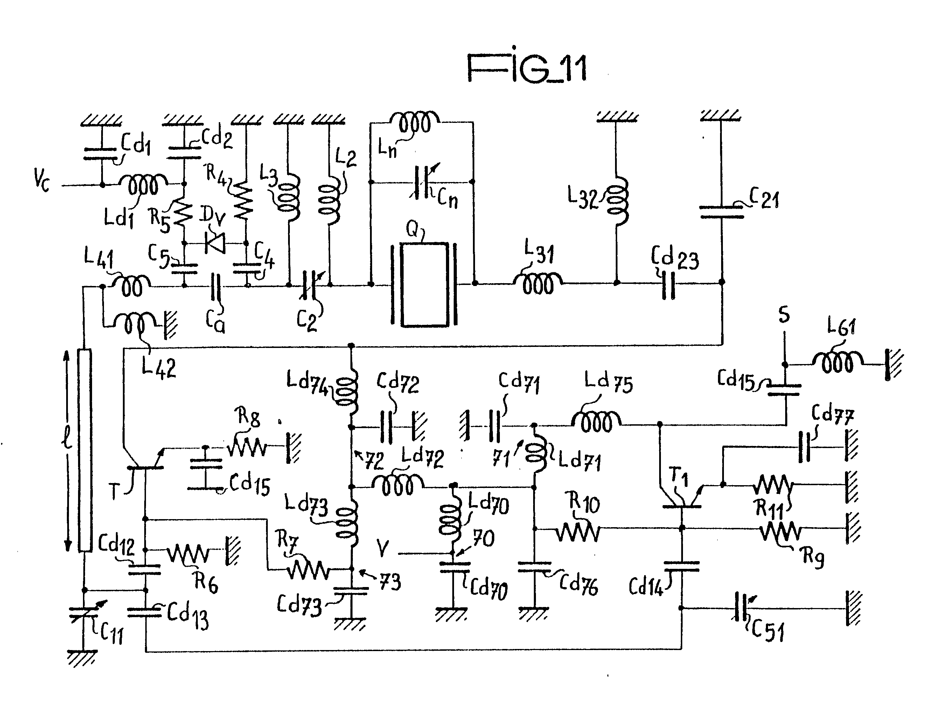

Selon la figure 10, l'oscillateur est réalisé en technologie micro-ruban 50 ohms. La polarisation des transistors T et $T_1$ n'a pas été représentée. Elle peut-être réalisée comme illustrée à la figure 11. L'amplificateur A est constitué par un transistor T du type BFP 91 de THOMSON-CSF. Il est monté en émetteur commun.

A la fréquence de travail, l'adaptation d'impédance à l'entrée et à la sortie du transistor T s'effectue par une longueur de ligne et un composant discret. Ainsi, l'adaptation à l'entrée du transistor T est réalisée par une longueur de ligne 10 et une self d'adaptation à la masse $L_{10}$. La longueur de ligne 10 et la self $L_{10}$ constituent le quadripôle $Q_1$ de la figure 9. De la même façon l'adaptation en sortie du transistor T s'effectue par une longueur de ligne 20 et un condensateur $C_{20}$ à la masse, constituant le quadripôle $Q_2$.

L'adaptation à l'entrée de la boucle de réaction s'effectue par une longueur de ligne 30 et un condensateur à la masse $C_{30}$ constituant le quadripôle $Q_3$. A la sortie de la boucle de réaction, l'adaptation est réalisée par une longueur de ligne 40 et une self à la masse $L_{40}$, constituant le quadripôle $Q_4$.

On remarquera que les composants mentionnés à la figure 10 ne sont donnés qu'à titre d'exemple. En effet, chacun des quadripôles peut utiliser comme élément d'adaptation une self ou une capacité suivant les résultats que donnent les mesures effectuées à l'aide de l'analyseur de réseau. En outre, les résultats peuvent être tels que pour un ou plusieurs des quadripôles, il ne soit pas besoin de mettre en œuvre un élément d'adaptation.

La longueur de ligne 40 débouche sur un diviseur D du type Wilkinson comportant deux branches formant un Y, chacune des branches ayant une longueur égale à $\lambda_0/4$ où $\lambda_0$ est la longueur d'onde correspondant à la fréquence $f_0$. Un tel diviseur peut être calculé par la méthode indiquée dans l'article N. Way Hybrid Power Divider, paru dans la revue IEE Microwave N° 1, 1969 sous la signature d'Ernest Wilkinson.

Une des branches du diviseur D débouche sur une longueur de ligne l dont la longueur sera choisie de telle façon que, à la fréquence $f_0$, la condition de phase de Barkausen soit respectée, c'est-à-dire que le déphasage de la boucle soit égale à 0 modulo 2 k$\pi$.

L'extrémité de l'autre branche du diviseur de Wilkinson débouche dans une ligne 50 qui attaque un transistor de sortie $T_1$ du même type que le transistor T et monté également en émetteur commun. A l'entrée, le transistor est adapté par la longueur de ligne 50 à laquelle est adjointe une self $L_{50}$ à la masse constituant le quadripôle $Q_5$, et à la sortie par une longueur de ligne 60 et un condensateur à la masse $C_{60}$, constituant le quadripôle $Q_6$. L'extrémité de la ligne 60 constitue la sortie S de l'oscillateur.

L'obtention de la courbe de réponse de la figure 4 nécessite, comme on l'a souligné plus haut, quelques précautions au niveau de l'adaptation d'impédance à l'entrée et à la sortie du quartz Q. Si on appelle $R_2$ l'impédance vue par le quartz en amont et $R_3$ l'impédance vue par celui en aval, le facteur de qualité Q à la fréquence $f_0$ du quartz s'écrit

$$Q = \frac{L_1 \omega_0}{(R_1 + R_2 + R_3)}$$

Il en résulte que, si les impédances vues par le quartz augmentent, le facteur de qualité Q de celui-ci se dégrade. Par contre, les pertes d'insertion diminuent.

Un compromis acceptable consiste à prendre $R_2 = R_3 = R_1/2$.

Ce compromis, qui correspond à une adaptation approximative conduit à une perte d'insertion qui n'est pas trop élevée (6 dB environ) et à une dégradation du facteur de qualité Q d'un rapport 2 seulement.

Dans le cas où on souhaite faire varier légèrement la fréquence de l'oscillateur, cette fonction peut-être réalisée à l'aide d'un circuit d'accord électronique de fréquence. Celui-ci comporte un condensateur fixe $C_a$ en série dans la boucle de réaction au borne duquel est branché le circuit d'accord proprement dit, comprenant une diode Varicap $D_v$ dont les deux bornes sont reliées aux bornes du condensateur $C_a$ par l'intermédiaire de deux condensateurs respectivement $C_4$ et $C_5$. La borne + de la diode Varicap $D_v$ est reliée à la masse par l'intermédiaire d'une résistance de polarisation $R_4$. La borne — de la diode Varicap $D_v$ reçoit une tension de commande $V_c$ à travers une résistance $R_5$. La tension de commande $V_c$ est découplée par une self de choc $L_{d1}$ branchée en série entre la résistance $R_5$ et l'alimentation à tension variable $V_c$. Aux bornes de la self $L_{d1}$, sont montés l'une des bornes de deux condensateurs de découplage $C_{d1}$, $C_{d2}$ dont l'autre borne est à la masse.

La variation de la valeur de la capacité de la diode Varicap $D_v$ a pour effet de faire varier légèrement le déphasage produit par la boucle de réaction. Celui-ci n'est plus nul modulo 2 $\pi$ à la fréquence $f_0$, mais à une fréquence $f'_0$ très voisine et située sur le pic $f_0$, et qui devient de ce fait la fréquence de l'oscillateur. Toute variation de $V_c$, par exemple par un diviseur potentiométrique, fait varier $f'_0$.

La figure 11 ne présente une réalisation en technologie composants discrets.

Un condensateur d'adaptation $C_{21}$ est connecté entre le collecteur du transistor T et la masse. Ce condensateur $C_{21}$ constitue l'élément d'adaptation du quadripôle $Q_2$.

Le quadripôle $Q_3$ est adapté grâce à une self série $L_{31}$ et une self parallèle $L_{32}$ dont une borne est à la masse.

Entre les deux quadripôles, est interposé un condensateur de découplage $C_{d23}$ qui a pour fonction d'éliminer le courant continu de la boucle. Le quadripôle $Q_4$ est adapté à l'aide d'une self série $L_{41}$ et d'une self parallèle $L_{42}$ dont une borne est à la masse.

Ce schéma laisse subsister la nécessité d'une longueur de ligne l réalisée dans le cas présent par une ligne coaxiale 50 ohms. En effet, un transistor en montage émetteur commun déphase le signal de $\pi$, d'où la nécessité d'introduire un déphasage supplémentaire notable pour satisfaire la condition de phase de Barkhausen à la fréquence $f_0$.

L'élément d'adaptation du quadripôle $Q_1$ à l'entrée du transistor T est constitué par un condensateur variable $C_{11}$ branché entre la sortie de la ligne coaxiale de longueur l et la masse. L'entrée de la base du transistor T est découplée par un condensateur série de découplage $C_{d12}$. L'émetteur du transistor T est chargé par une résistance $R_8$ et découplé par un condensateur de découplage $C_{d16}$, branché entre l'émetteur de $T_1$ et la masse.

Le prélèvement du signal de sortie s'effectue simplement par l'intermédiaire d'un condensateur de découplage $C_{d13}$, c'est-à-dire que les deux transistors T et $T_1$ sont alimentés en parallèle à partir de la sortie de la ligne coaxiale de longueur l sans autre précaution que l'adaptation d'impédance du quadripôle $Q_5$ réalisée par un condensateur variable $C_{51}$ branché entre la base du transistor $T_1$, en amont d'un condensateur de découplage $C_{d14}$, et la masse.

La sortie S du transistor $T_1$ est adaptée par une self parallèle $L_{61}$ dont une borne est à la masse (quadripôle $Q_6$) et les tensions continues pouvant éventuellement se trouver présentes à la sortie du collecteur du transistor $Q_1$ sont découplées par un condensateur de découplage $C_{d15}$.

L'émetteur du transistor $T_1$ est chargé par une résistance $R_{11}$ et découplé par un condensateur de découplage $C_{d77}$ branché entre l'émetteur de $T_1$ et la masse.

La polarisation des transistors T et $T_1$ s'effectue à partir d'une tension V découplée notamment par une série de quatre cellules 70 à 73 composées chacune d'une self de choc $L_d$ (indicée de 70 à 73) disposée en série, et d'un condensateur de découplage $C_d$ (indicé de 70 à 73) monté en parallèle et dont une borne est à la masse.

La première cellule 70 reçoit la tension V à une première borne de sa self $L_{d70}$ dont la deuxième borne est reliée à une extrémité d'un pont diviseur résistif $R_9$, $R_{10}$ dont le point milieu est relié à la base du transistor $T_1$. Entre $R_{10}$ et la masse, est également branché un condensateur de découplage $C_{d76}$. La deuxième borne de la self $L_{d70}$ attaque une cellule 71 dont la self $L_{d71}$ est reliée au collecteur du transistor $T_1$ par une self $L_{d75}$. Elle attaque également une cellule 72 dont la self $L_{d72}$ est reliée au collecteur du transistor T par l'intermédiaire d'une self $L_{d75}$, ainsi qu'une cellule 73 dont la self $L_{d73}$ reliée à une extrémité d'un pont diviseur résistif $R_6$, $R_7$ dont le point milieu est relié à la base du transistor T.

A titre d'exemple, les selfs de choc utilisées pour le découplage ont une valeur de 1 $\mu$H et les condensateurs de découplage, une valeur de 1 nF. En ce qui concerne la diode Varicap $D_v$, elle peut avoir une valeur nominale de 30 pF, et on prend $C_4 = C_5 = 2,2$ pF et $R_4 = R_5 = 10$ k$\Omega$. Les valeurs des autres éléments résultent des calculs indiqués ci-dessus, notamment en ce qui concernent les adaptations d'impédance. On notera que ces dernières dépendent non seulement du quartz utilisé mais également du transistor utilisé. Deux transistors même issus de la même série ne présentent pas en effet exactement les mêmes propriétés. Notons par ailleurs qu'un quartz résonnant à 1 GHz présente à cette fréquence une impédance caractéristique (résistance $R_1$) d'environ 400 $\Omega$.

L'invention ne se limite pas aux modes de réalisation décrits et représentés. En particulier, l'ordre dans lequel les éléments de la boucle de réaction (quartz, filtre et éventuellement accord électronique de

5

**0 139 583**

fréquence) sont disposés est indifférent. D'autre part, le prélèvement du signal de sortie par un diviseur de puissance, qui peut être de tout type connu, peut s'opérer en tout point de la boucle. En outre, le diviseur de puissance peut être remplacé par un coupleur directionnel.

## Revendications

1. Oscillateur à quartz pour très hautes fréquences comportant un amplificateur (A) et une boucle de réaction comprenant un quartz dont une fréquence de résonance donnée ($f_0$) est choisie comme fréquence de l'oscillateur, l'amplicateur ayant un gain tel qu'en boucle ouverte la condition de gain de Barkhausen soit satisfaite, le quartz (Q) étant compensé à ladite fréquence ($f_0$) par un circuit parallèle comprenant au moins une self ($L_n$), caractérisé en ce que la fréquence de résonance choisie est au moins égale à 1 GHz, l'amplificateur comporte un transistor monté en émetteur commun, la boucle de réaction comprenant également un filtre passe-haut (F) assurant une coupure des fréquences inférieures à ladite fréquence de résonance ($f_0$), des circuits adaptateurs permettent, d'une part, l'adaptation des impédances de la boucle de réaction à l'amplificateur et, d'autre part, que cette boucle de réaction présente un déphasage nul à $2\,k\pi$ près, k étant un nombre entier, un diviseur de puissance permet de prélever une partie du signal de la boucle de réaction pour l'injecter dans un amplificateur de sortie ($A_1$).

2. Oscillateur selon la revendication 1, caractérisé en ce que ledit circuit parallèle comporte également un condensateur de compensation ($C_n$).

3. Oscillateur selon la revendication 2, caractérisé en ce que le condensateur ($C_n$) est un condensateur variable.

4. Oscillateur selon une des revendications précédentes, caractérisé en ce que la boucle de réaction comporte un circuit d'accord électronique de fréquence.

5. Oscillateur selon la revendicatin 4, caractérisé en ce que ledit circuit d'accord électronique de fréquence comporte un condensateur fixe ($C_c$) en série dans la boucle de réaction, et aux bornes duquel est branchée une diode Varicap ($D_v$) alimentée par un circuit de commande de tension ($V_c$).

6. Oscillateur selon une des revendications précédentes, caractérisé en ce que ledit filtre (F) comporte un filtre en $\pi$ comprenant un condensateur série ($C_2$) variable encadré de deux selfs ($L_2$, $L_3$) dont une borne est à la masse.

7. Oscillateur selon une des revendications précédentes, caractérisé en ce qu'il est réalisé sous forme de ligne et en ce qu'il comporte des composants discrets distribués le long des sections de lignes de la boucle de manière à réaliser les adaptations d'impédances dans la boucle et en ce que la longueur cumulée des sections de ligne est telle que la boucle présente un dit déphasage nul à $2\,k\pi$ près.

8. Oscillateur selon les revendications 6 et 7 prises ensemble, caractérisé en ce que lesdites deux selfs ($L_2$, $L_3$) sont des sections de lignes de longueur inférieure au quart ($\lambda_0/4$) de la longueur d'onde de ladite fréquence ($f_0$) de l'oscillateur.

9. Oscillateur selon une des revendications 7 ou 8, caractérisé en ce que le diviseur de puissance est un diviseur de puissance $\lambda_0/4$ de type Wilkinson.

## Claims

1. A quartz oscillator for very high frequencies including an amplifier (A) and a feedback loop comprising a quartz, the given resonance frequency ($f_0$) of which is chosen as oscillator frequency, the amplifier having a gain such that the Barkhausen gain condition at open loop is met, the quartz (Q) being compensated at said frequency ($f_0$) by a parallel circuit comprising at least one inductance ($L_n$), characterized in that the chosen resonance frequency is at least equal to 1 GHz, the amplifier comprises an emitter follower transistor, the feedback loop further comprising a high pass filter (F) rejecting frequencies below said resonance frequency ($f_0$), that matching circuits on the one hand allow to match the impedances of the feedback loop to the amplifier and cause on the other hand the feedback loop to have a phase shift of $2\,k\pi$, k being an integer, that a power divider is conceived to extract a portion of the signal from the feedback loop, this portion being injected into an output amplifier ($A_1$).

2. An oscillator according to claim 1, characterized in that the parallel circuit further includes a compensation capacitor ($C_n$).

3. An oscillator according to claim 2, characterized in that the capacitor ($C_n$) is a capacitor of variable capacitance.

4. An oscillator according to one of the preceding claims, characterized in that the feedback loop comprises an electronic frequency tuning circuit.

5. An oscillator according to claim 4, characterized in that said electronic frequency tuning circuit comprises a fixed capacitor ($C_c$) in series in the feedback loop, and a Varicap-diode ($D_v$) which is supplied by a voltage control circuit ($V_c$) and is connected to the terminals of said fixed capacitor.

6. An oscillator according to one of the preceding claims, characterized in that said filter (F) presents a $\pi$-structure and includes a variable series capacitor ($C_2$) and two inductances ($L_2$, $L_3$) on either side thereof, one terminal of each inductance being connected to ground.

6

7. An oscillator according to one of the preceding claims, characterized in that it is realized as a line and that it comprises discrete components distributed along line sections of the loop such that the impedance matchings in the loop are ensured, and that the accumulated length of the line sections is such that the loop presents a said phase shift of $2\,k\pi$.

8. An oscillator according to claims 6 and 7 taken together, characterized in that said two inductances ($L_2$, $L_3$) are line sections, the length of which is smaller than a quarter wavelength ($\lambda_0/4$) at said frequency ($f_0$) of the oscillator.

9. An oscillator according to one of claims 7 or 8, characterized in that the power divider is a $\lambda_0/4$-power divider of the Wilkinson type.

## Patentansprüche

1. Quarzoszillator für sehr hohe Frequenzen mit einem Verstärker (A) und einer Rückkopplungsschleife, in der sich ein Quarz befindet, dessen gegebene Resonanzfrequenz ($f_0$) als Frequenz des Oszillators gewählt wird, wobei der Verstärker einen solchen Verstärkungsgrad aufweist, daß die Barkhausen-Verstärkungsbedingung bei offener Schleife erfüllt ist, und wobei der Quarz (Q) bei dieser Frequenz ($f_0$) durch einen mindestens eine Spule ($L_n$) enthaltenden Parallelkreis kompensiert ist, dadurch gekennzeichnet, daß die Resonanzfrequenz mindestens gleich 1 GHz ist, daß der Verstärker einen Transistor in Emitterbasisschaltung aufweist, daß die Gegenkopplungsschleife auch ein Hochpassfilter (F) enthält, das die unter der Resonanzfrequenz ($f_0$) liegenden Frequenzen abschneidet, daß Anpassungskreise einerseits die Impedanzanpassung der Gegenkopplungsschleife an den Verstärker erlauben und andererseits dazu führen, daß diese Gegenkopplungsschleife eine Phasenverschiebung von $2\,k\pi$ aufweist, wobei k eine ganze Zahl ist, und daß ein Leistungsaufteiler die Entnahme eines Teils des Signals der Gegenkopplungsschleife erlaubt, un diesen Teil in einen Ausgangsverstärker ($A_1$) einzuspeisen.

2. Oszillator nach Anspruch 1, dadurch gekennzeichnet, daß der Parallelkreis außerdem einen Kompensationskondensator ($C_n$) aufweist.

3. Oszillator nach Anspruch 2, dadurch gekennzeichnet, daß der Kondensator ($C_n$) ein variabler Kondensator ist.

4. Oszillator nach einem der vorhergehenden Ansprüche, dadurch gekennzeichnet, daß die Rückkopplungsschleife einen elektronischen Frequenzabstimmungskreis enthält.

5. Oszillator nach Anspruch 4, dadurch gekennzeichnet, daß der elektronische Frequenzabstimmungskreis einen Festkondensator ($C_c$) in Reihe in der Gegenkopplungsschleife aufweist, und daß an den Klemmen dieses Festkondensators eine Varicap-Diode ($D_v$) angeschlossen ist, die aus einem Spannungssteuerkreis ($V_c$) gespeist wird.

6. Oszillator nach einem der vorhergehenden Ansprüche, dadurch gekennzeichnet, daß das Filter (F) ein -Filter enthält, das einen variablen Reihenkondensator ($C_2$) der aufweist, der von zwei Spulen ($L_2$, $L_3$) eingerahmt ist, deren eine Klemme an Masse liegt.

7. Oszillator nach einem der vorhergehenden Ansprüche, dadurch gekennzeichnet, daß er in Leitungsform ausgebildet ist und entlang von Leitungsabschnitten der Schleife verteilte diskrete Bauelemente enthält, so daß die Impedanzanpassungen in der Schleife erreicht werden, und daß die Kumulierte Länge der Leitungsabschnitte so gewählt ist, daß die Schleife die erwähnte Phasenverschiebung von $2\,k\pi$ besitzt.

8. Oszillator gemäß den beiden Ansprüche 6 und 7, dadurch gekennzeichnet, daß die beiden Spulen ($L_2$, $L_3$) Leitungsabschnitte sind, deren Länge geringer als eine Viertelwellenlänge ($\lambda_0/4$) bei der Frequenz $f_0$ des Oszillators ist.

9. Oszillator nach einem der Ansprüche 7 oder 8, dadurch gekennzeichnet, daß der Leistungsaufteiler ein Leistungsaufteiler $\lambda_0/4$ vom Wilkinson-Typ ist.

FIG_1

FIG_2

Pertes d'insertion

0dB

-3dB

1dB

$f_0 \simeq 1G \, Hz$

$f$

Pertes d'insertion

-15dB

B

C

FIG_3

$f_0$

$f$

Pertes d'insertion

0dB

FIG_4

-6dB

$f_0$

$f$

FIG_5

FIG_6

FIG_9

## FIG_7-a

## FIG_7-b

## FIG_7-c

## FIG_8

FIG_10

$Z_0 = 50\,\Omega$

0 139 583

FIG_11